(19) Europäisches Patentamt
European Patent Office
Office européen des brevets

(11) **EP 0 603 507 B1**

(12) **EUROPÄISCHE PATENTSCHRIFT**

(45) Veröffentlichungstag und Bekanntmachung des Hinweises auf die Patenterteilung:
**22.07.1998 Patentblatt 1998/30**

(51) Int Cl.⁶: **H03F 1/34**, H03F 3/187

(21) Anmeldenummer: **93117691.1**

(22) Anmeldetag: **02.11.1993**

(54) **Verstärkerschaltung für Tonsignale**

Amplifier circuit for audio signals

Circuit d'amplification pour des signaux sonores

(84) Benannte Vertragsstaaten:
**AT DE DK GB**

(30) Priorität: **21.12.1992 DE 4243344**

(43) Veröffentlichungstag der Anmeldung:
**29.06.1994 Patentblatt 1994/26**

(73) Patentinhaber: **WERKSTÄTTE FÜR STUDIO-TECHNIK Dipl.-Ing. Hellmut Haufe D-61250 Usingen (DE)**

(72) Erfinder: **Haufe, Dieter D-61250 Usingen (DE)**

(74) Vertreter: **Säger, Manfred, Dipl.-Ing. Postfach 505 9004 St. Gallen (CH)**

(56) Entgegenhaltungen:
**EP-A- 0 041 472        DE-A- 1 913 302
FR-A- 1 295 540**

**Beschreibung**

Die Erfindung betrifft eine Schaltungsanordnung.

Schaltungsanordnungen mit Ausgangs-Übertrager sind bekannt (EP-0 041 472). Ebenso sind solche mit Spannungs-Übertragern üblich (FR-1 295 540).

Schließlich sind Operationsverstärker-Schaltungen mit Stromeingang und Spannungsausgang mit einem durch einen Übertrager potential getrennten Wechselstrom-Eingang bekannt. Hierbei wird die Sekundärseite des Übertragers zwischen dem Ausgang des Verstärkers und den zweiten Eingang des Operationsverstärkers angeschlossen. Die Primärseite des Übertragers bildet den potential getrennten Stromeingang der Schaltung. Solche Schaltungen werden zum Beispiel für Summierungsanordnungen in der professionellen Tonstudiotechnik aus Gründen der Betriebssicherheit verwendet.

Weitere derartige Schaltungsanordnungen mit Vorwiderständen werden als potential getrennte Spannungseingangsstufen verwendet, wobei auch für hohe Eingangsspannungen und niedrige Frequenzen relativ kleine Übertrager verwendet werden können.

Allerdings besitzt der verwendete Übertrager unerwünschte Eigenschaften: So wird durch seinen Wirkwiderstand der Eingangswiderstand der Gesamtschaltungsanordnung vergrößert, was für Summierungsanordnungen ungünstig ist. Ferner bildet die primärseitige Hauptinduktivität mit dem sekundärseitigen Wirkwiderstand des Übertragers einen frequenzabhängigen Stromteiler, der einen unerwünschten Frequenzgang ergeben kann. Bei einem magnetisierbaren Kern des Übertragers ist der Stromteiler außerdem nichtlinear, was zu einem unerwünschten Klirrfaktor führt. Schließlich besteht aus Gründen der Rauschübertragungsfunktion der Gesamtschaltung die Forderung nach einer möglichst großen Hauptinduktivität des Übertragers, was bei Berücksichtigung der oben genannten weiteren Faktoren zu großen und teuren Bauformen führt.

Der Erfindung liegt die Aufgabe zugrunde, eine Schaltungsanordnung vorzuschlagen, die möglichst frequenzunabhängig und bei möglichst großer Hauptinduktivität zu dennoch kleinen Bauformen des Übertragers führt.

Diese Aufgabe wird bei einer gattungsgemäßen Schaltungsanordnung erfindungsgemäß durch den Hauptanspruch gelöst.

Erfindungsgemäß ist es bei unverändertem Übertrager möglich, den Eingangswiderstand der Schaltung zu verringern oder den Klirrfaktor und den Frequenzgang zu verbessern.

Zweckmäßige Ausgestaltungen und Weiterbildungen der Erfindung sind in den Unteransprüchen gekennzeichnet.

Bevorzugte Ausführungsbeispiele der Erfindung werden nachfolgend unter Bezugnahme auf die Zeichnung näher erläutert. In dieser zeigt:

Figur 1    eine erste Ausführungsform der erfindungsgemäßen Schaltung;

Figur 2    die Schaltungsanordnung gemäß Figur 1, wobei der Übertrager durch sein Ersatzschaltbild ersetzt ist;

Figur 3    eine weitere Ausführungsform der erfindungsgemäßen Schaltung mit kapazitiver Ankopplung des (+) Eingangs des Operationsverstärkers (OP) und

Figur 4    eine dritte Ausführungsform mit kapazitiver Ankopplung des (-) Eingangs des Operationsverstärkers (OP).

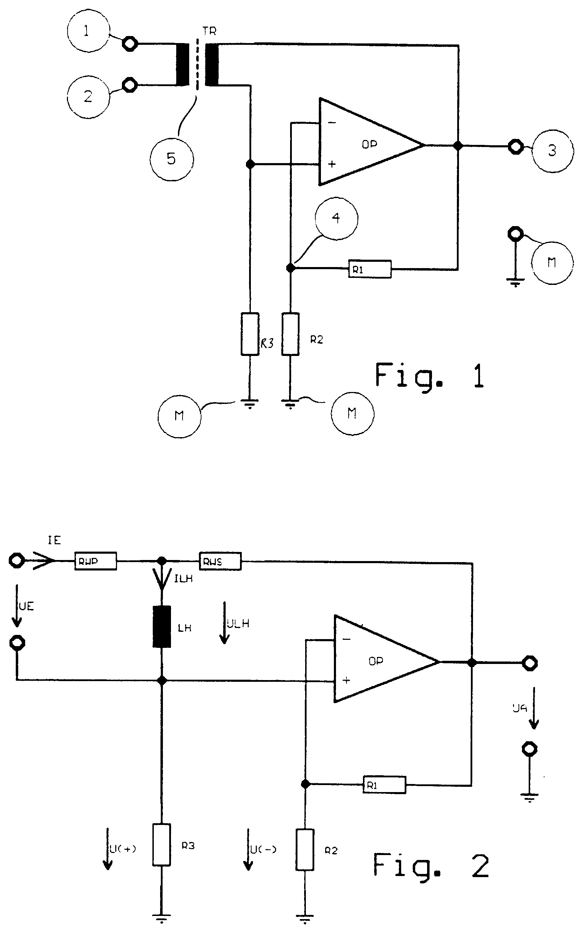

In der Schaltungsanordnung nach Figur 1 ist ein Operationsverstärker OP dargestellt, mit einem invertierenden ersten (-) und einen nicht-invertierenden zweiten Eingang (+).

Zwischen dem Eingang und dem Ausgang (3) des Operationsverstärkers (OP) liegt die Sekundärwicklung eines Übertragers (TR) als Stromübertrager an dessen primärseitigen Eingangsklemmen (1, 2) der Eingangsstrom eingespeist wird. Weiterhin liegt zwischen dem zweiten Eingang (+) des Operationsverstärkers (OP) und der Bezugsmasse (M) der Widerstand (R3), der den Übertragungsfaktor der Schaltungsanordnung bestimmt.

Ferner ist zwischen dem Ausgang 3 und der Bezugsmasse M ein Netzwerk, bestehend aus dem Spannungsteiler mit den Spannungsteilerwiderständen R1 und R2 geschaltet, dessen gemeinsamer Anschluß 4 mit dem ersten Eingang (-) des Operationsverstärkers OP verbunden ist.

Anhand der in Figur 2 dargestellten Schaltung mit einem Ersatzschaltbild des Übertragers, bestehend aus primärseitigen Wirkwiderstand RWP, dem sekundärseitigem Wirkwiderstand RWS sowie der Hauptinduktivität LH soll nunmehr die Auswirkung dieses Netzwerkes erläutert werden, wobei bei den nachfolgenden Berechnungen vereinfacht von einem Übertrager mit einem Übersetzungsverhältnis 1 : 1 ausgegangen wird. Bei Übertragern mit anderem Übersetzungsverhältnis gelten die Berechnungen mit auf die Sekundärseite des Übertragers TR transformierten Werten sinngemäß. Bei folgenden Berechnungen wird zunächst davon ausgegangen, daß der Strom ILH duch die Hauptinduktivität LH vernachlässigt werden kann. Für die angegebene Schaltung gelten folgende Gleichungen:

$$U (-) = UA * R2 / (R1 + R2) \qquad (1)$$

$$U (+) = -IE * R3 \qquad (2)$$

$$ULH = -U (+) + IE * RWS + UA \qquad (3)$$

$$UE = -U(+) + IE * (RWP+RWS) + UA \qquad (4)$$

Für einen idealen Operationsverstärker gilt weiterhin

$$U (+) = U (-) \qquad (5)$$

Hieraus ergibt sich:

$$ULH = IE * (RWS - R3 * R1 / R2) \qquad (6)$$

$$UE = IE * (RWP + RWS - R3 * R1 / R2) \qquad (7)$$

Ohne die erfindungsgemäßen Zusätze ist der erste Eingang des Operationsverstärkers OP mit dem Ausgang 3 verbunden. Die Spannungen U (+) und U (-) sind dann wegen Gleichung (5) gleich UA. An der Hauptinduktivität LH liegt die Spannung IE * RWS. Sobald der Strom ILH=ULH/w*L nicht mehr gegenüber dem Eingangsstrom vernachlässigt werden kann, tritt eine Stromteilung auf, die zu linearen Verzerrungen führt. Ist der Strom durch die Induktivität nichtlinear, weil diese zum Beispiel einen magnetisierbaren Kern mit nichtlinearer Magnetisierungskennlinie besitzt, so führt dies insgesamt zu nichtlinearen Verzerrungen der gesamten Schaltungsanordnung.

Wählt man nun das Verhältnis R1/R2 so, daß R3 * R1/R2 = RWS wird, so wird der Ausdruck ULH in Gleichung (6) zu Null, so daß an der Hauptinduktivität LH die Spannung ebenfalls gegen Null geht. In diesem Fall fließt durch die Induktivität kein Strom mehr. Infolgedessen können im Übertrager keine Verzerrungen entstehen und es findet auch keine frequenzabhängige Stromteilung statt. In diesem Dimensionierungsfall sind somit die Einflüsse des Übertragers TR auf den Klirrfaktor und den Frequenzgang eliminiert.

Substitutiert man den Ausdruck (R1/R2)/(RWS/R3) durch den Faktor K, so ist dieser Fall bei K = 1 gegeben.

Wählt man das Verhältnis R1/R2 so, daß R3* R1/R2 2 =RWS+ RWP wird, so wird der Ausdruck UE in Gleichung (7) zu Null, so daß der Eingangswiderstand der Schaltung ebenfalls Null wird. In diesem Dimensionierungsfall sind die Einflüsse des Übertragers TR auf den Eingangsscheinwiderstand eliminiert. In diesem Fall ist k = (RWS+RWP)/RWS.

Bei der Realisierung der Schaltungsanordnung ist noch eine Reihe von Randbedingungen zu berücksichtigen, die zu den in den Unteransprüchen beanspruchten Ausführungsformen führen. Die Schaltung besitzt einen Spannungsteiler, gebildet durch die Spannungsteilerwiderstände R2 und R1, einen Gegenkopplungszweig und mit einem Spannungsteiler, gebildet aus R3 und der Reihenschaltung RWS und LH einen Mitkopplungszweig. Aus Stabilitätsgründen ist es erforderlich, daß die Gegenkopplung größer ist als die Mitkopplung. Dies ist bei hohen Frequenzen wegen der Induktivität LH immer der Fall, bei tiefen Frequenzen ist jedoch zu gewährleisten, daß RWS/R3 größer als R1/R2 ist.

Weiterhin besteht der Wirkwiderstand RWS üblicherweise aus der aus Kupferdraht gefertigten Sekundärwicklung des Stromübertragers, die einen Temperaturkoeffizienten von ca. 4000 ppm/Kelvin besitzt. Somit ist dieser Spannungsteilerzweig relativ stark temperaturabhängig. Wird die Schaltung innerhalb eines größeren Temperaturbereichs betrieben, so sind folgende Lösungen möglich:

Im einfachsten Fall wird der Faktor k bei Raumtemperatur so gewählt, daß innerhalb des gesamten Temperaturbereichs der Faktor kleiner 1 ist, die Verbesserung des Klirrfaktors und des Frequenzgangs ist dann ebenfalls temperaturabhängig.

Andererseits besteht die Möglichkeit, den Spannungsteiler, gebildet aus den Spannungsteilerwiderständen R2 und R1 derart aus temperaturabhängigen Widerständen auszuführen, daß dieser Spannungsteiler einen gleichen oder ähnlichen Temperaturgang wie der Spannungsteiler, gebildet aus den Widerständen R3 und dem sekundären Wirkwiderstand RWS besitzt.

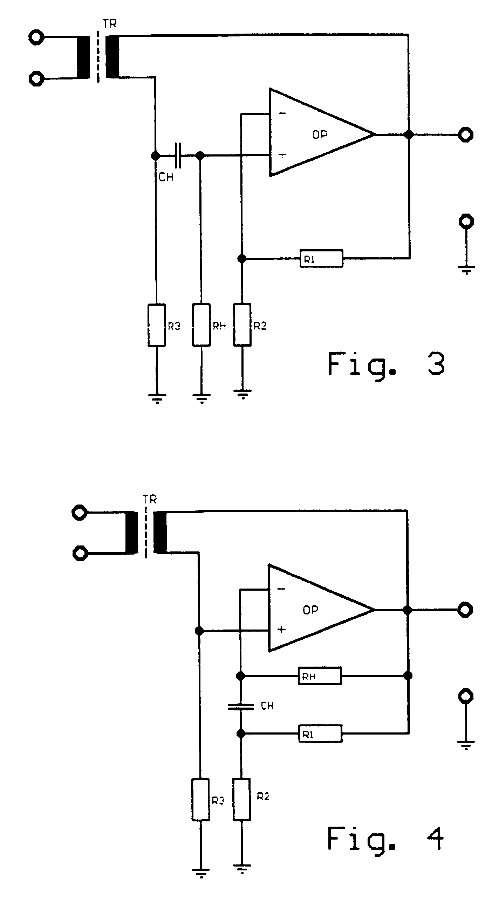

Außerdem ist zur Erreichung einer tieffrequenten Stabilität es auch möglich, sowohl den zweiten Eingang des Operationsverstärkers OP als auch dessen ersten Eingang mit dem Rest der Schaltung kapazitiv mittels eines Kondensators C zu koppeln. Mögliche Ausführungsvarianten sind in den Figuren 3 und 4 dargestellt. Durch die Elemente CH und RH werden der zweite Eingang und der erste Eingang des Operationsverstärkers OP mit dem Rest der Schaltung so gekoppelt, daß der Arbeitspunkt des Operationsverstärkers OP hinreichend stabil ist. Hierbei ist die Grenzfrequenz der verwendeten Koppelelemente derartig zu wählen, daß im Nutzfrequenzbereich die Wirkung der Schaltung noch gewährleistet ist.

Schaltungsvarianten mit kapazitiver Kopplung sind in jedem Fall dann erforderlich, wenn der sekundärseitige RWS und der primärseitige RWP des Übertragers TR kompensiert werden sollen, da hierfür ein Faktor k > 1 erforderlich ist, was bei reiner Gleichspannungskopplung zur Instabilität führt.

**Patentansprüche**

1. Schaltungsanordnung mit einem Stromeingang (IE) über Eingangsanschlüssen (1, 2) und einem Spannungsausgang (UA) über Ausgangsanschlüssen (3, M), die mit einem Eingangs-Strom-Übertrager (TR) mit dem Übersetzungsverhältnis (1:Ü), der primärseitigen Hauptinduktivität (LH) und dem primärseitigen (RWP) sowie dem sekundärseitigen Wirkwiderstand (RWS) versehen ist, wobei die Primärseite des Übertragers (TR) mit den Eingangsanschlüssen (1, 2) versehen ist, sowie einen Operationsverstärker (OP) mit einem invertierenden ersten Eingang (-) und einem nicht-invertierenden zweiten Eingang (+) sowie einem Ausgang aufweist, der mit den Ausgangsanschlüssen (3, M) verbunden ist, wobei die Sekundärseite des Übertragers (TR) zwischen dem Ausgang und dem zweiten Eingang (+) des Operationsverstärkers (OP) angeschlossen ist, welcher seinerseits über einen Widerstand (R3) an die Bezugsmasse (M) angeschlossen ist, wobei zwischen den Ausgangsanschluß (3) des Operationsverstärkers (OP) und der Bezugsmasse (M) ein Spannungsteiler, bestehend aus den Spannungsteilerwiderständen (R1, R2) geschaltet ist, deren gemeinsamer Anschluß (4) an den ersten Eingang (-) des Operationsverstärkers (OP) angeschlossen ist (Fig.1).

2. Schaltungsanordnung nach Anspruch 1, dadurch gekennzeichnet, daß ein Faktor (k) vorgesehen und mit $0 < k < \infty$ derartig gewählt ist,

$$k = \frac{R1/R2}{RWS/R3}$$

da bei einem in die Primärseite des Übertragers (TR) hineinfließenden Strom durch den in der Sekundärseite des Übertragers hineinfließenden Strom die Spannung (ULH) entweder an der primärseitigen Hauptinduktivität (LH) oder die Spannung (UE) an den Eingangsanschlüssen (1, 2) des Übertragers (TR) minimal wird (Figur 2).

3. Schaltungsanordnung nach Anspruch 2, dadurch gekennzeichnet, daß $0,5 < k \leq 1$.

4. Schaltungsanordnung nach einem der Ansprüche 1 bis 3, dadurch gekennzeichnet, daß der Temperaturkoeffizient des Spannungsteilers (R1, R2) annähernd gleich jenem des Spannungsteilers, gebildet aus dem Widerstand (R3) und dem sekundärseitigen Wirkwiderstand (RWS) ist.

5. Schaltungsanordnung nach einem der Ansprüche 1 bis 4, dadurch gekennzeichnet, daß an den ersten Eingang (-) des Operationsverstärkers (OP) der eine Anschluß eines Kondensators (C) angeschlossen ist, dessen anderer Anschluß an dem gemeinsamen Anschluß ( 4) liegt (Figur 4).

6. Schaltungsanordnung nach einem der Ansprüche 1 bis 4, dadurch gekennzeichnet, daß an den zweiten Eingang (+) des Operationsverstärkers der eine Anschluß eines Kondensators (C) angeschlossen ist, dessen anderer Anschluß zwischen dem Übertrager (TR) und dem Widerstand (R3) liegt. (Figur 3).

7. Schaltungsanordnung nach Anspruch 5 oder 6, dadurch gekennzeichnet, daß $0,9 < k < 1,1$ ist.

8. Schaltungsanordnung nach Anspruch 5 oder 6, dadurch gekennzeichnet, daß k gleich (RWS + Ü * Ü * RWP)/RWS gewählt wird.

9. Schaltungsanordnung nach einem der vorangegangenen Ansprüche, dadurch gekennzeichnet, daß der Übertrager mit einem magnetisierbarem Kern (5) versehen ist.

10. Schaltungsanordnung nach einem der Ansprüche 1 bis 9, dadurch gekennzeichnet, daß den Eingangsanschlüssen (1, 2) ein oder mehrere weitere Widerstände in Reihe so geschaltet werden, daß die Schaltungsanordnung insgesamt die Eingangscharakteristik eines Spannungseingangs erhält.

**Claims**

1. A circuit arrangement having a current input (IE) by way of input terminals (1, 2) and a voltage output (UA) by way of output terminals (3, M), which is provided with an input current transformer (TR) with the transformation ratio (1:Ü), the primary-side main inductance (LH) and the primary-side active resistance (RWP) and the secondary-side active resistance (RWS), wherein the primary side of the transformer (TR) is provided with the input terminals (1, 2), and has an operational amplifier (OP) with an inverting first input (-) and a non-inverting second input (+) as well as an output which is connected to the output terminals (3, M), wherein the secondary side of the transformer (TR) is connected between the output and the second input (+) of the operational amplifier (OP), which in turn is connected by way of a resistor (R3) to the reference earth (M), wherein connected between the output terminal (3) of the operational amplifier (OP) and the reference earth (M) is a voltage divider comprising the voltage divider resistors (R1, R2) whose common terminal (4) is connected to the first input (-) of the operational amplifier (OP) (Figure 1).

2. A circuit arrangement according to claim 1 characterised in that there is provided a factor (k) which is so selected with $0<k<\infty$ that

$$k = \frac{R1/R2}{RWS/R3}$$

as in the case of a current flowing into the primary side of the transformer (TR), due to the current flowing in the secondary side of the transformer either the voltage (ULH) at the primary-side main inductance (LH) or the voltage (UE) at the input terminals (1, 2) of the transformer (TR) becomes a minimum (Figure 2).

3. A circuit arrangement according to claim 2 characterised in that 0.5<k≤1.

4. A circuit arrangement according to one of claims 1 to 3 characterised in that the temperature coefficient of the voltage divider (R1, R2) is approximately equal to that of the voltage divider formed from the resistor (R3) and the secondary-side active resistance (RWS).

5. A circuit arrangement according to one of claims 1 to 4 characterised in that connected to the first input (-) of the operational amplifier (OP) is the one terminal of a capacitor (C) whose other terminal is connected to the common connection (4) (Figure 4).

6. A circuit arrangement according to one of claims 1 to 4 characterised in that connected to the second input (+) of the operational amplifier is the one terminal of a capacitor (C) whose other terminal is between the transformer (TR) and the resistor (R3) (Figure 3).

7. A circuit arrangement according to claim 5 or claim 6 characterised in that 0.9 < k < 1.1.

8. A circuit arrangement according to claim 5 or claim 6 characterised in that k is selected to be equal to (RWS + Ü * Ü * RWP)/RWS.

9. A circuit arrangement according to one of the preceding claims characterised in that the transformer is provided with a magnetisable core (5).

10. A circuit arrangement according to one of claims 1 to 9 characterised in that one or more further resistors are so connected in series with the input terminals (1, 2) that the circuit arrangement overall has the input characteristic of a voltage input.

## Revendications

1. Montage de circuits comportant une entrée du courant (IE) à travers des bornes d'entrée (1, 2) et une sortie de la tension (UA) à travers des bornes de sortie (3, M), lequel est muni d'un transformateur (TR) du courant d'entrée à rapport surmultiplicateur (1:Ü), de l'inductivité principale côté primaire (LH) et de la résistance du côté primaire (RWP) ainsi que de la résistance effective côté secondaire (RWS), le côté primaire du transformateur (TR) étant muni de bornes d'entrée (1, 2) et présente un amplificateur opérationnel (OP) comportant une première entrée (-) inversable et une deuxième entrée (+) non-inversable, ainsi qu'une sortie reliée aux bornes de sortie (3,M), tandis que le côté secondaire du transformateur (TR) est connecté entre la sortie et la deuxième entrée (+) de l'amplificateur (OP), laquelle entrée est, pour sa part, raccordée à la masse de référence (M) à travers une résistance (R3) et, entre laquelle borne de sortie (3) de l'amplificateur (OP) et la masse de référence (M), est prévu un diviseur de tension constitué des résistances (R1, R2) dont la borne commune (4) est raccordée à la première entrée (-) de l'amplificateur opérationnel (OP) (Figure 1).

2. Montage de circuits selon la revendication 1, **caractérisé** par la présence d'un facteur (k), répondant à la relation O < k < ∞ qui a été sélectionné de telle manière que :

$$k = \frac{R1/R2}{RWS/R3}$$

grâce à quoi, avec un courant pénétrant dans le côté primaire du transformateur (TR), le courant pénétrant dans le côté secondaire du transformateur a pour effet que devienne minimale ou bien la tension (ULH) appliquée à l'inductance principale côté primaire (LH) ou bien la tension (UE) appliquée aux bornes d'entrée (1, 2) du transformateur (TR) (Figure 2).

3. Schéma de circuit selon la revendication 2, **caractérisé** en ce que 0,5 < k ≤ 1.

4. Montage de circuits selon l'une des revendications 1 à 3, **caractérisé** en ce que le coefficient thermique du diviseur de tension (R1, R2) est sensiblement égal à celui du diviseur de tension formé par la résistance (R3) et la résistance effective (RWS) du côté secondaire.

5. Montage de circuits selon l'une des revendications 1 à 4, **caractérisé** en ce que, à la première entrée (-) de l'amplificateur (OP) est raccordée une borne d'un condensateur (C) dont l'autre borne s'applique à la borne commune (4) (Figure 4).

6. Montage de circuits selon l'une des revendications 1 à 4, **caractérisé** en ce qu'à la deuxième entrée (+) de l'amplificateur opérationnel est raccordée une borne d'un condensateur (C) dont l'autre borne s'applique entre le transformateur (TR) et la résistance (R3) (Figure 3).

7. Montage de circuits selon les revendications 5 ou 6, **caractérisé** en ce que 0,9 < k < 1,1.

8. Montage de circuits selon les revendications 5 ou 6, **caractérisé** en ce que k est égal à :

$$(RWS + Ü * Ü * RWP)/RWS.$$

9. Montage de circuits selon l'une des revendications précédentes, **caractérisé** en ce que le transformateur est muni d'un noyau magnétisable (5).

10. Montage de circuits selon l'une des revendications 1 à 9, **caractérisé** en ce qu'aux bornes d'entrée (1, 2) sont montées en série une seule ou plusieurs autres résistances de telle sorte que globalement le montage de circuits présente la courbe caractéristique d'entrée d'une entrée de tension.

Fig. 1

Fig. 2

Fig. 3

Fig. 4